# EUROPÄISCHE PATENTSCHRIFT

(11) **EP 0 931 267 B1**
(45) Veröffentlichungstag und Bekanntmachung des Hinweises auf die Patenterteilung: **03.01.2001**
(21) Anmeldenummer: 97911140.8
(22) Anmeldetag: 14.10.1997
(51) Int. Cl.: G01R 15/14

(54) **VERFAHREN UND ANORDNUNG ZUR STROMMESSUNG**
METHOD AND DEVICE FOR MEASURING CURRENT
PROCEDE ET DISPOSITIF DE MESURE DE COURANT

(30) Priorität: 14.10.1996 DE 19642381
(43) Veröffentlichungstag der Anmeldung: 28.07.1999
(73) Patentinhaber: SIEMENS AKTIENGESELLSCHAFT, 80333 München (DE)
(72) Erfinder: ERMISCH, Jochen, D-01445 Radebeul (DE); STEPHAN, Uwe, D-01705 Freital (DE); THIEME, Frank, D-01099 Dresden (DE); BAUERSCHMIDT, Peter, D-91126 Schwabach (DE)
(86) Internationale Anmeldenummer: DE9702348
(87) Internationale Veröffentlichungsnummer: WO9816839

(56) Entgegenhaltungen:
- EP-A- 0 288 998
- EP-A- 0 510 311
- DE-A- 4 424 368
- FR-A- 2 727 209
- US-A- 4 728 887

## Beschreibung

Die Erfindung bezieht sich auf ein Verfahren zur Strommessung, insbesondere in einer gasisolierten Spannungsschaltanlage, z.B. in einer Hoch- oder Mittelspannungsanlage. Sie bezieht sich weiter auf eine Strommeßanordnung zur Durchführung des Verfahrens.

Zur Messung von Strömen in einer derartigen gasisolierten Schaltanlage wird üblicherweise ein sogenannter Meßwandler oder Meßsensor als Stromwandler eingesetzt, wobei als Isoliergas in der Regel ein mit SF6 bezeichnetes Gas verwendet wird. Der Meßwandler umfaßt im wesentlichen als Informationsgeber eine Spule, die einen einen Primärstrom führenden Stromleiter der Anlage konzentrisch umgibt. Dabei wird ein in der Spule fließender Sekundärstrom als Meßsignal herangezogen, das in einer auch als Leittechnik für Schaltanlagen (LSA) bezeichneten Baugruppe einer Automatisierungseinrichtung verarbeitet wird.

Wie in dem Aufsatz "20 Jahre Forschung auf dem Gebiet nicht konventioneller Wandler", in ELEKTRIE, Berlin 43 (1989) 6, Seiten 205 bis 207, beschrieben, kann prinzipiell zwischen zwei unterschiedlichen Wandlerprinzipien unterschieden werden. Bei einem sogenannten konventionellen Wandler sind der Informationsgeber und eine diesem zugeordnete Energiequelle primärseitig an den Stromleiter der Anlage gekoppelt und sekundärseitig gemeinsam mit der eigentlichen Bürde verbunden. Dieser Wandler benötigt allerdings ein großes Einbauvolumen. Demgegenüber ist bei einem sogenannten nichtkonventionellen Wandler lediglich der Informationsgeber primärseitig an den Stromleiter der Anlage gekoppelt. Bei dem nichtkonventionellen Wandler ist daher eine Hilfsenergiequelle erforderlich, die zur Beibehaltung gewünschter Nennausgangsströme des Sekundärkreises von 5 bzw. 1A zumindest kurzzeitig eine Leistung bis zu einigen kW abzugeben in der Lage ist. Daher ist ein entsprechende Parameter aufweisender Leistungsverstärker erforderlich, über den der Informationsgeber mit der Bürde verbunden ist. Für diesen Wandlertyp eignet sich besonders eine optische Lösung, die jedoch nur mit sehr hohen Kosten zu realisieren ist.

Angestrebt wird daher häufig eine Zwischenlösung, der das herkömmliche oder konventionelle Meßprinzip - allerdings auf leistungsarmen Niveau - zugrundeliegt. Ein auf dieser Zwischenlösung basierender leistungsarmer Meßwandler ist in der Herstellung jedoch insbesondere dann besonders kompliziert, wenn eine große sättigungsfreie Zeit benötigt wird.

Aus der europäischen Patentanmeldung 0 510 311 A2 ist es darüber hinaus bekannt, für eine metallgekapselte, gasisolierte Hochspannungsanlage einen nach dem Prinzip der Rogowski-Spule arbeitenden Stromwandler einzusetzen. Eine Strommeßanordnung nach dem Prinzip der Rogowski-Spule ist auch aus der deutschen Offenlegungsschrift DE 44 24 368 A1 bekannt. Um bei Verwendung einer Rogowski-Spule eine hohe Abbildungstreue im Meßbereich zu erzielen, ist ein großer Aufwand mit entsprechend hohen Kosten erforderlich. Grund hierfür ist, daß einerseits die Meßgenauigkeit der Rogowski-Spule durch eine Vielzahl von Faktoren bestimmt ist, und daß andererseits aufgrund der systembedingten off-line-Anordnung besondere Vorkehrungen für eine hohe Zuverlässigkeit und Parameterkonstanz erforderlich sind.

Der Erfindung liegt daher die Aufgabe zugrunde, ein besonders geeignetes Verfahren und eine besonders geeignete Anordnung zur präzisen Messung von Strömen mit hohem Dynamikbereich anzugeben.

Bezüglich des Verfahrens wird diese Aufgabe gelöst, indem ein erstes Signal eines ersten leistungsarmen Meßwandlers mit Magnetkern und ein zweites Signal eines zweiten magnetfreien, insbesondere optischen, Meßwandlers miteinander verglichen werden. In Abhängigkeit von der Genauigkeit der Abbildung des gemessenen Stroms wird anschließend eines der beiden Signale ausgewählt und weiterverarbeitet. Als Vergleichskriterium wird eine Abweichung der beiden von den Meßwandlern unterschiedlichen Typs abgegebenen Signale voneinander ausgewertet.

Die Erfindung geht dabei von der Überlegung aus, daß mit geringem Aufwand und kleinen Einbaumaßen eine genaue Messung von Strömen mit hohem Dynamikbereich durch die Verwendung eines kombinierten Strommeßgliedes erreicht werden kann. Dabei sollte lediglich ein Sensor oder Wandler im eigentlichen Meßbereich betrieben werden, während ein anderer Sensor im wesentlichen im Überstrombereich verwendet wird. Dabei kann die Abbildungstreue oder Genauigkeit im Meßbereich durch einen leistungsarmen Meßwandler gewährleistet werden, während eine Rogowski-Spule oder ein nach dem Faraday-Effekt arbeitender optischer Meßwandler die Abbildung hoher, stationärer oder verlagerter Ströme übernimmt. Gemäß dem Faraday-Effekt erfolgt eine Drehung der Polarisationsebene linear polarisierten Lichts in einem optisch inaktiven Material bei Vorhandensein eines magnetischen Feldes parallel zur Ausbreitungsrichtung des Lichts.

Zweckmäßigerweise werden die von den beiden Meßwandlern getrennt erfaßten Signale, d. h. deren Ausgangsspannungen, gemeinsam verarbeitet. Die Ausgangsspannung des leistungsarmen Meßwandlers fällt im Falle dessen Sättigung ab. Dabei ist der Gradient, z. B. die erste oder die zweite Ableitung, dessen Ausgangsspannung größer als der Gradient der Ausgangsspannung des nach dem Prinzip der Rogowski-Spule oder nach dem Faraday-Effekt arbeitenden Meßwandlers. Die Ableitung der Ausgangsspannungen nach der Zeit kann somit als Maß für die Genauigkeit der beiden Signale herangezogen werden. Daher wird zweckmäßigerweise als Kriterium für eine Umschaltung vom Ausgangssignal des leistungsarmen Meßwandlers auf das Ausgangssignal der Rogowski-Spule oder des optischen Meßwandlers der Gradient der Ausgangsspannungen oder Ausgangssignale der beiden Meßwandler berücksichtigt. Alternativ oder zusätzlich kann zur Bildung eines Umschaltkriteriums und damit zur Bestimmung des Grads der Genauigkeit auch eine Überprüfung und Auswertung von charakteristischen Merkmalen der beiden Ausgangssignale mittels eines Fuzzy-Controllers und/oder eines neuronalen Netzes erfolgen.

Bezüglich der Anordnung zur Strommessung wird die genannte Aufgabe gelöst durch die Merkmale des Anspruchs 6. Vorteilhafte Ausgestaltungen sind Gegenstand der auf diesen rückbezogenen Unteransprüche.

Die Strommeßanordnung umfaßt ein kombiniertes Strommeßglied mit einem leistungsarmen Meßwandler und einem leistungslosen oder optischen Meßwandler, insbesondere einer Rogowski-Spule. Dem leistungsarmen Meßwandler ist zweckmäßigerweise eine Eingangsbaugruppe zur Pegelanpassung und Potentialtrennung nachgeschaltet. Die Eingangsbaugruppe umfaßt zweckmäßigerweise als Signalverstärker einen Operationsverstärker sowie ein spannungsbegrenzendes Bauelement in Form einer bipolaren Zenerdiode als Schutzschaltung zur Gewährleistung der elektromagnetischen Verträglichkeit (EMV-Schutz).

Demgegenüber ist dem zweiten Meßwandler, d. h. insbesondere der Rogowski-Spule, zweckmäßigerweise ein passiver Vorintegrator nachgeschaltet, dem - wiederum über einen EMV-Schutz in Form einer bipolaren Zenerdiode - ein Verstärker nachgeschaltet ist. Dieser kann z. B. auch ein Isolationstrennverstärker sein.

Beide Meßwandler sind über die ihnen nachgeschalteten Baugruppen mit einem gemeinsamen Verarbeitungsbaustein zur Signalverarbeitung verbunden. Der Verarbeitungsbaustein oder die Verarbeitungsbaugruppe umfaßt für die von den Meßwandlern abgegebenen Signale jeweils einen Analog/Digital-Wandler (A/D-Wandler). Bei Verwendung lediglich eines einzelnen A/D-Wandlers für beide Signale gemeinsam ist diesem ein Multiplexer vorgeschaltet. Die Auswertung und Weiterverarbeitung der von den Meßwandlern übertragenen Signale erfolgt zweckmäßigerweise auf der Digitalseite.

Die mit der Erfindung erzielten Vorteile bestehen insbesondere darin, daß durch Einsatz eines kombinierten Strommeßgliedes mit einem leistungsarmen Meßwandler und mit einer Rogowski-Spule sowohl eine hohe Abbildungstreue im Meßbereich als auch ein gutes Übertragungsverhalten bei verlagerten Strömen im Überstrombereich und damit eine hohe sättigungsfreie Zeit erreicht wird. Der Aufwand und damit die Kosten sind bei Verwendung eines derartigen kombinierten Strommeßgliedes im Vergleich zu einem konventionellen Meßwandler mit nachgeschaltetem A/D-Wandler besonders gering. Die Anordnung zeichnet sich außerdem durch eine hohe Zuverlässigkeit und ein besonders geringes Einbauvolumen in einer gasisolierten Schaltanlage aus. Außerdem ist ein direkter Anschluß an elektronische Schutzeinrichtungen problemlos möglich.

Ein Ausführungsbeispiel der Erfindung wird anhand einer Zeichnung näher erläutert. Darin zeigen:

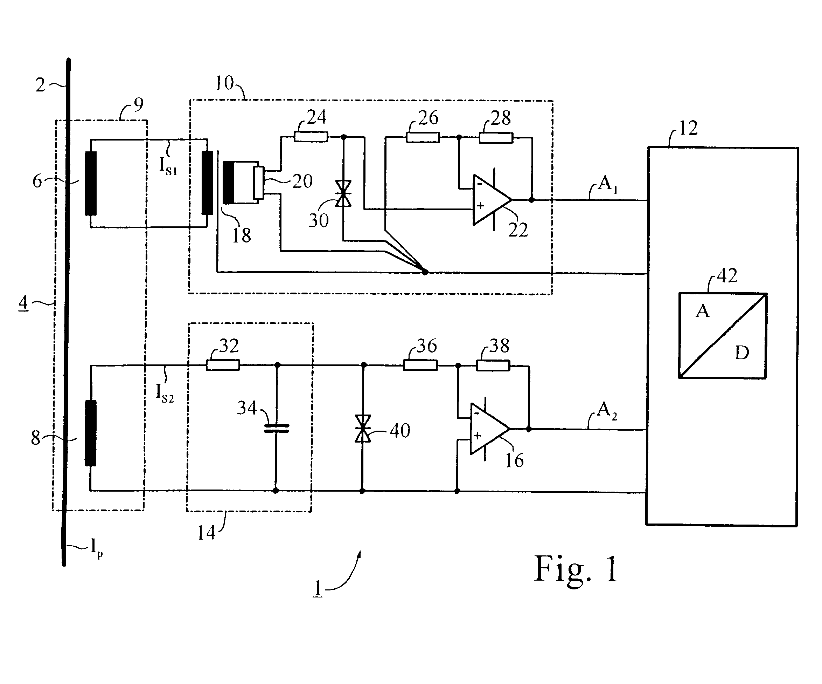

- FIG 1: eine Strommeßanordnung mit einem leistungsarmen Meßwandler sowie mit einer Rogowski-Spule als magnetfreien Meßwandler und
- FIG 2: ausgangsseitige Stromverläufe der beiden Meßwandler.

Die Anordnung 1 zur präzisen Messung von Strömen mit hohem Dynamikbereich umfaßt ein kombiniertes Strommeßglied mit um einen stromdurchflossenen Leiter 2 in einem Teil einer gasisolierten Schaltanlage 4 angeordnetem leistungsarmen Meßwandler 6 oder Weitbereichswandler und mit einer Rogowski-Spule 8. Der leistungsarme Meßwandler 6 und die Rogowski-Spule 8 sind in einem gemeinsamen Gehäuse 9 angeordnet. Der leistungsarme Meßwandler 6 ist über eine Eingangsbaugruppe oder einen Eingangsbaustein 10 mit einem Verarbeitungsbaustein oder einer Verarbeitungsbaugruppe 12 verbunden. Die Rogowski-Spule 8 ist über eine Hintereinanderschaltung aus einem passiven Vorintegrator 14 und einem Operationsverstärker 16 an die Verarbeitungsbaugruppe 12 einer Leittechnik für Schaltanlagen (LSA) angeschlossen. Anstelle der Rogowski-Spule 8 kann auch ein nach dem Faraday-Effekt arbeitender optischer Meßwandler vorgesehen sein.

Der dem leistungsarmen Meßwandler 6 nachgeschaltete Eingangsbaustein 10 umfaßt einen Anpaß- oder Zwischenwandler 18 mit einem Anpaßwiderstand oder Shunt 20 und einen Operationsverstärker 22 mit diesem zugeordneten Widerständen 24, 26 und 28, durch deren Werteverhältnisse zueinander die Verstärkung des Operationsverstärkers 22 bestimmt ist. Der Eingangsbaustein 10 umfaßt außerdem eine EMV-Schutzschaltung 30 in Form einer bipolaren Zenerdiode.

Der der Rogowski-Spule 8 nachgeschaltete passive Vorintegrator 14 umfaßt einen Widerstand 32 und einen Kondensator 34. Der Operationsverstärker 16 mit verstärkungsbestimmenden Widerständen 36 und 38 ist eingangsseitig über einen weiteren EMV-Schutz 40 - wiederum in Form einer bipolaren Zenerdiode - an den passiven Vorintegrator oder Integratorbaustein 14 und ausgangsseitig an den Verarbeitungsbaustein 12 angeschlossen.

Während des Betriebs wird ein im stromdurchflossenen Leiter 2 geführter Primärstrom I_{P} sowohl vom leistungsarmen Meßwandler 6 als auch von der Rogowski-Spule 8 erfaßt. Dieser Primärstrom Ip wird vom leistungsarmen Meßwandler 6 in einen Sekundärstrom I_{S1} und in der Rogowski-Spule 8 in einen Sekundärstrom I_{S2} umgewandelt. In dem dem leistungsarmen Meßwandler 6 nachgeschalteten Eingangsbaustein 10 wird der Sekundärstrom I_{S1} in ein erstes Ausgangssignal A₁ umgeformt, das dem Verarbeitungsbaustein 12 zugeführt wird. Analog wird der Sekundärstrom I_{S2} der Rogowski-Spule 8 mittels des passiven Vorintegrators 14 und des Operationsverstärkers 16 in ein zweites Ausgangssignal A₂ überführt. Im Verarbeitungsbaustein 12 werden die Ausgangssignale A₁ und A₂ zunächst einem A/D-Wandler oder einem Multiplexer 42 zugeführt. Die Verarbeitung der Signale A₁ und A₂ erfolgt dann auf der Digitalseite.

Im stationären Betrieb wird der im stromdurchflossenen Leiter 2 geführte Primärstrom I_{P} vom leistungsarmen Meßwandler 6 erfaßt und ausschließlich in dem diesem nachgeschalteten Eingangsbaustein 10 verarbeitet, so daß lediglich das erste Ausgangssignal A₁ im Verarbeitungsbaustein 12 ausgewertet und weiterverarbeitet wird. Das Ausgangssignal A₂ der Rogowski-Spule 8 wird in diesem Meßbereich nicht ausgewertet.

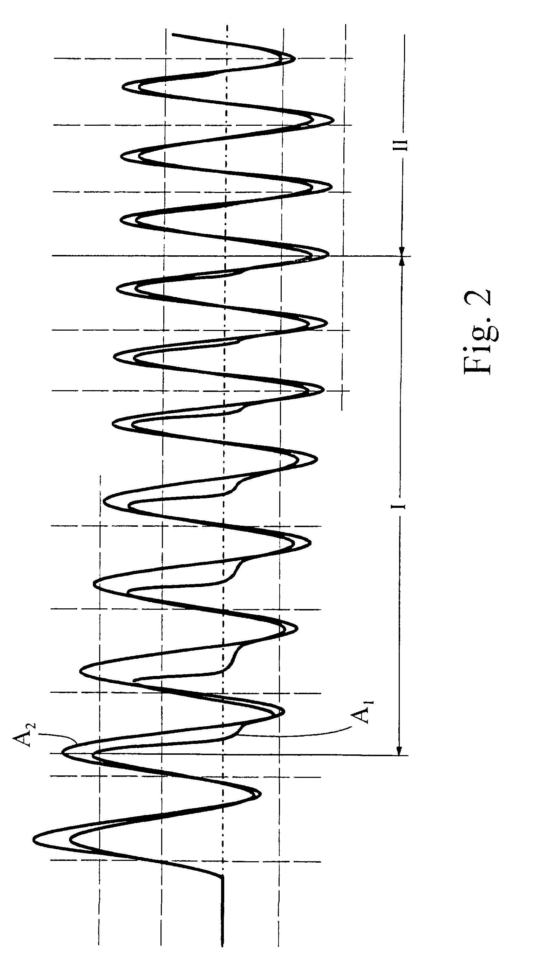

FIG 2 zeigt typische Amplituden/Zeit-Verläufe der Ausgangssignale A₁, A₂ bei Beaufschlagung der beiden Meßwandler 6 bzw. 8 mit einem voll verlagerten Primärstrom I_{P}. Demnach kann auch im stationären Überstrombereich (Bereich II) das vom leistungsarmen Meßwandler 6 gelieferte Ausgangssignal A₁ dann noch für eine Weiterverarbeitung verwendet werden, wenn noch keine Sättigung des (nicht dargestellten) Magnetkerns des leistungsarmen Meßwandlers 6 vorliegt. Im Fall verlagerter Primärströme I_{P} erreicht der Magnetkern des leistungsarmen Meßwandlers 6 seine Sättigung mit entsprechendem Verlauf des Ausgangssignals A₁ (Bereich I). Die Kurvenform des ersten Ausgangssignals A₁ am Ausgang des Eingangsbausteins 10 wird dann erheblich von derjenigen Kurvenform des zweiten Ausgangssignals A₂ abweichen, das hinter der sättigungsfreien Rogowski-Spule 8 und nach einer Vorverarbeitung mit dem Integratorbaustein 14 und dem Operationsverstärker 16 anliegt.

Im Anschluß an eine in dem Verarbeitungsbaustein 12 erfolgte numerische Integration des hinter dem Operationsverstärker 16 anliegenden Ausgangssignals A₂ erfolgt ein Vergleich der Kurvenformen beider Ausgangssignale A₁ und A₂ im Verarbeitungsbaustein 12. Im Ergebnis eines derartigen Vergleiches stimmen die Kurvenformen des Ausgangssignals A₁ des leistungsarmen Meßwandlers 6 einerseits und des Ausgangssignals A₂ der Rogowski-Spule 8 andererseits bis zum Eintritt der Sättigung des Magnetkerns des leistungsarmen Meßwandlers 6 relativ gut überein. Dabei wird als Vergleichskriterium insbesondere der Gradient der Ausgangsspannungen der Ausgangssignale A₁ und A₂ herangezogen. Daraus läßt sich der Grad der Genauigkeit der beiden Ausgangssignale A₁ und A₂ ableiten. Grund hierfür ist, daß die Ausgangsspannung des leistungsarmen Meßwandlers 6 im Fall der Sättigung stärker fällt als die Ausgangsspannung der Rogowski-Spule 8, so daß der Gradient des Ausgangssignals A₁, d. h. zunächst dessen erste Ableitung, beim leistungsarmen Meßwandler 6 größer ist als der Gradient des Ausgangssignals A₂ der Rogowski-Spule 8. Diese Abweichung der beiden Ausgangssignale A₁ und A₂ wird dann als Kriterium für eine Umschaltung vom Ausgangssignal A₁ des leistungsarmen Meßwandlers 6 auf das Ausgangssignal A₂ der Rogowski-Spule 8 herangezogen.

Der leistungsarme Meßwandler 6 gewährleistet somit eine hohe Abbildungstreue und Genauigkeit im eigentlichen Meßbereich. Die Rogowski-Spule 8 wird daher nicht als Sensor im Meßbereich und in großen Teilen des Schutzbereiches betrieben. Vielmehr ist alleiniger Verwendungszweck der Rogowski-Spule 8 die Abbildung hoher, stationärer oder verlagerter Ströme im Überstrombereich. Dies wiederum gewährleistet eine hohe sättigungsfreie Zeit der gesamten Anordnung.

Die Genauigkeit im Meßbereich ist mit vorgegebenen Restriktionen bezüglich des Einbauvolumens mit einem leistungsarmen Meßwandler 6 im Bereich der in der IEC-Norm 185 angegebenen Klassengenauigkeiten - z. B. der Klasse 0,2 - realisierbar. Die Zuverlässigkeit der gesamten Anordnung 1 kann somit deutlich höher bewertet werden, als die Zuverlässigkeit einer Rogowski-Spule 8 allein. Die Forderung, die sättigungsfreie Zeit des leistungsarmen Meßwandlers 6 mindestens auf dem derzeit erreichten Stand zu halten, gestattet zumindest bis zu den Grenzen des leistungsarmen Meßwandlers 6 eine sichere Meßwerterfassung. Bei einem entsprechenden Schutzkonzept ist eine genügende Reserve bei Ausfall der Auswertelektronik der Rogowski-Spule 8 oder des leistungsarmen Wandlers 6 möglich.

## Patentansprüche

1. Verfahren zur Strommessung, insbesondere in einer gasisolierten Spannungsschaltanlage, bei dem ein erstes Signal (A1) eines ersten leistungsarmen Meßwandlers (6) mit Magnetkern und ein zweites Signal (A₂) eines zweiten magnetfreien Meßwandlers (8) verglichen werden, und bei dem in Abhängigkeit von der Genauigkeit der Abbildung des gemessenen Stromes (Ip) eines der beiden Signale (A₁, A₂) ausgewählt und weiterverarbeitet wird, wobei als Vergleichskriterium eine Abweichung der beiden Signale (A₁, A₂) voneinander ausgewertet wird.

2. Verfahren nach Anspruch 1, bei dem der magnetfreie Meßwandler (8) ein nach dem Prinzip einer Rogowski-Spule arbeitender Meßwandler ist.

3. Verfahren nach Anspruch 1, bei dem der magnetfreie Meßwandler (8) ein nach dem Prinzip des Faraday-Effekts arbeitender optischer Meßwandler ist.

4. Verfahren nach einem der Ansprüche 1 bis 3, bei dem die beiden voneinander getrennt erfaßten Signale (A₁, A₂) gemeinsam verarbeitet werden.

5. Verfahren nach einem der Ansprüche 1 bis 4, wobei als Maß für die Abbildungsgenauigkeit die Ableitung des oder jedes Signals (A₁, A₂) nach der Zeit herangezogen wird.

6. Anordnung zur Strommessung, insbesondere in einer gasisolierten Spannungsschaltanlage, mit einem ersten leistungsarmen Meßwandler (6) mit Magnetkern und mit einem zweiten magnetfreien Meßwandler (8), insbesondere einer Rogowski-Spule oder einem nach dem Faraday-Prinzip arbeitenden optischen Meßwandler,
- wobei jeder Meßwandler (6,8) einen in einem stromdurchflossenen Leiter (2) geführten Primärstrom (Iₚ) erfaßt und in einen Sekundärstrom (I_{S1} bzw. I_{S2}) umwandelt,
- wobei ein dem ersten Meßwandler (6) nachgeschalteter Eingangsbaustein (10) den Sekundärstrom (Iₚ) des ersten Meßwandlers (6) in ein erstes Ausgangssignal (A₁) umwandelt und einem Verarbeitungsbaustein (12) zuführt,
- wobei eine dem zweiten Meßwandler (8) nachgeschaltete Hintereinanderschaltung aus einem Integratorbaustein (14) und einem Signalverstärker (16) den Sekundärstrom (I_{S2}) des zweiten Meßwandlers (8) in ein zweites Ausgangssignal (A₂) überführt und dem Verarbeitungsbaustein (12) zuführt, und
- wobei anhand eines Vergleichs der Kurvenformen der beiden Ausgangssignale (A₁,A₂) im Verarbeitungsbaustein (12) bei Erreichen der Sättigung des Magnetkerns des ersten Meßwandlers (6) eine Umschaltung vom ersten Ausgangssignal (A₁) auf das zweite Ausgangssignal (A₂) erfolgt.

7. Anordnung nach Anspruch 6, wobei der Eingangsbaustein (10) einen Anpaßwandler (18) und einen Signalverstärker (22), vorzugsweise einen Operationsverstärker, umfaßt.

8. Anordnung nach Anspruch 6 oder 7, wobei der Eingangsbaustein (10) ein spannungsbegrenzendes Bauelement (30), vorzugsweise eine bipolare Zenerdiode, umfaßt.

9. Anordnung nach einem der Ansprüche 6 bis 8, wobei der Integratorbaustein (14) ein passiver Vorintegrator mit einem Widerstand (32) und einem Kondensator (34) ist.

10. Anordnung nach einem der Ansprüche 6 bis 9, wobei dem zweiten Meßwandler (8) ein spannungsbegrenzendes Bauelement (40), vorzugsweise eine bipolare Zenerdiode, nachgeschaltet ist.

11. Anordnung nach einem der Ansprüche 6 bis 10, wobei der Verarbeitungsbaustein (12) mindestens einen A/D-Wandler ggf. mit vorgeschaltetem Multiplexer (42) umfaßt.

12. Anordnung nach einem der Ansprüche 6 bis 11, wobei der erste Meßwandler (6) und der zweite Meßwandler (8) in einem gemeinsamen Gehäuse (9) einer gasisolierten Schaltanlage (4) angeordnet sind.

## Claims

1. Method for current measurement, in particular in a gas-insulated voltage switchgear, wherein a first signal (A₁) of a first low-output measuring transducer (6) with magnet core, and a second signal (A₂) of a second magnet-free measuring transducer (8) are compared, and wherein, as a function of the accuracy of the image of the measured current (Ip) one of the two signals (A₁, A₂) is selected and processed further, wherein a deviation of the two signals (A₁, A₂) from each other is evaluated as comparison criterion.

2. Method according to claim 1, wherein the magnet-free measuring transducer (8) is a measuring transducer operating according to the principle of a Rogovski coil.

3. Method according to claim 1, wherein the magnet-free measuring transducer (8) is an optical measuring transducer operating according to the principle of the Faraday effect.

4. Method according to one of claims 1 to 3, wherein the two signals (A₁, A₂) detected separately from each other are processed together.

5. Method according to one of claims 1 to 4, wherein the derivation of the or each signal (A₁, A₂) after the period is used as measure for the image accuracy.

6. Arrangement for current measurement, in particular in a gas-insulated voltage switchgear, with a first low-output measuring transducer (6) with magnet core, and with a second magnet-free measuring transducer (8), in particular a Rogovski coil or an optical measuring transducer operating according to the Faraday principle,
- wherein each measuring transducer (6, 8) detects a primary current (Iₚ) carried in a current-carrying conductor (2) and converts it into a secondary current (I_{S1} or I_{S2}),
- wherein an input module (10) downstream of the first measuring transducer (6) converts the secondary current (Iₚ) of the first measuring transducer (6) into a first output signal (A₁) and supplies it to a processing module (12),
- wherein a series connection comprising an integrator module (14) and a signal amplifier (16), downstream of the second measuring transducer (8), converts the secondary current (I_{S2}) of the second measuring transducer (8) into a second output signal (A₂) and supplies it to the processing module (12), and
- wherein, with the aid of a comparison of the waveforms of the two output signals (A₁, A₂) in the processing module (12), upon reaching the saturation of the magnet core of the first measuring transducer (6) a switch-over from the first output signal (A₁) to the second output signal (A₂) takes place.

7. Arrangement according to claim 6, wherein the input module (10) comprises a matching transformer (18) and a signal amplifier (22), preferably an operational amplifier.

8. Arrangement according to claim 6 or 7, wherein the input module (10) comprises a voltage-limiting component (30), preferably a bipolar Zener diode.

9. Arrangement according to one of claims 6 to 8, wherein the integrator module (14) is a passive series integrator with a resistor (32) and a capacitor (34).

10. Arrangement according to one of claims 6 to 9, wherein a voltage-limiting component (40), preferably a bipolar Zener diode, is downstream of the second measuring transducer (8).

11. Arrangement according to one of claims 6 to 10, wherein the processing module (12) comprises at least one A/D converter, optionally with upstream multiplexer (42).

12. Arrangement according to one of claims 6 to 11, wherein the first measuring transducer (6) and the second measuring transducer (8) are arranged in a common housing (9) of a gas-insulated switchgear (4).

## Revendications

1. Procédé pour mesurer le courant électrique, notamment dans une installation de coupure de tension isolée par du gaz, dans lequel on compare un premier signal (A₁) d'un premier transformateur (6) de mesure à faible puissance à noyau magnétique et un deuxième signal (A₂) d'un deuxième transformateur (8) de mesure sans aimant, et dans lequel on sélectionne en fonction de la précision de la représentation du courant (Ip) mesuré, l'un des deux signaux (A₁,A₂) et on le traite ultérieurement, un écart des deux signaux (A₁,A₂) l'un par rapport à l'autre étant exploité comme critère de comparaison.

2. Procédé suivant la revendication 1, dans lequel le transformateur (8) de mesure sans aimant est un transformateur de mesure travaillant suivant le principe d'une bobine de Rogowski.

3. Procédé suivant la revendication 1, dans lequel le transformateur (8) de mesure sans aimant est un transformateur de mesure optique travaillant suivant le principe de l'effet de Faraday.

4. Procédé suivant l'une des revendications 1 à 3, dans lequel les deux signaux (A₁,A₂) détectés séparément l'un de l'autre sont traités en commun.

5. Procédé suivant l'une des revendications 1 à 4, la dérivée par rapport au temps du ou de chaque signal (A₁,A₂) étant utilisée comme mesure de la précision de la représentation.

6. Dispositif pour mesurer le courant électrique, notamment dans une installation de coupure de tension isolée par du gaz, comportant un premier transformateur (6) de mesure à faible puissance à noyau magnétique et comportant un deuxième transformateur (8) de mesure sans aimant, notamment une bobine de Rogowski ou un transformateur de mesure optique travaillant suivant le principe de Faraday,
- chaque transformateur (6,8) de mesure détectant un courant (Iₚ) primaire passant dans un conducteur (2) dans lequel passe du courant et le transformant en un courant (Iₛ₁ ou Iₛ₂) secondaire,
- un module (10) d'entrée, monté en aval du premier transformateur (6) de mesure, transformant le courant (Iₚ) secondaire du premier transformateur (6) de mesure en un premier signal (A₁) de sortie et l'envoyant à un module (12) de traitement,
- un circuit série, constitué d'un module (14) intégrateur et d'un amplificateur (16) de signaux, monté en aval du deuxième transformateur (8) de mesure, transformant le courant (I_{S2}) secondaire du deuxième transformateur (8) de mesure en un deuxième signal (A₂) de sortie et l'envoyant au module (12) de traitement, et
- une commutation du premier signal (A₁) de sortie au deuxième signal (A₂) de sortie s'effectuant à l'aide d'une comparaison de la forme des courbes des deux signaux (A₁, A₂) de sortie dans le module (12) de traitement lorsque la saturation du noyau magnétique du premier transformateur (6) de mesure est atteinte.

7. Dispositif suivant la revendication 6, le module (10) d'entrée comportant un transformateur (18) d'adaptation et un amplificateur (22) de signaux, de préférence un amplificateur opérationnel.

8. Dispositif suivant la revendication 6 ou 7, le module (10) d'entrée comprenant un composant (30) limitant la tension, de préférence une diode Zener bipolaire.

9. Dispositif suivant l'une des revendications 6 à 8, le module (14) intégrateur étant un préintégrateur passif comportant une résistance (32) et un condensateur (34).

10. Dispositif suivant l'une des revendications 6 à 9, un composant (40) limitant la tension, de préférence une diode Zener bipolaire, étant monté en aval du deuxième transformateur (8) de mesure.

11. Dispositif suivant l'une des revendications 6 à 10, le module (12) de traitement comprenant au moins un convertisseur analogique/numérique, le cas échéant à multiplexeur (42) monté en amont.

12. Dispositif suivant l'une des revendications 6 à 11, le premier transformateur (6) de mesure et le deuxième transformateur (8) de mesure étant montés dans un boîtier (9) commun d'une installation (4) de coupure isolée par du gaz.
